# EUROPEAN PATENT SPECIFICATION

(11) **EP 2 972 433 B1**
(45) Date of publication and mention of the grant of the patent: **08.03.2017**
(21) Application number: 13796171.0
(22) Date of filing: 28.10.2013
(51) Int. Cl.: G01R 31/36, H02J 7/34, H02J 9/06

(54) **SYSTEM FOR AUTOMATION OF MEASUREMENT OF BACKUP-BATTERIES CAPACITY IN A TELECOMMUNICATIONS POWER STATION**
SYSTEM ZUR AUTOMATISIERUNG DER MESSUNG EINER NOTSTROMBATTERIEKAPAZITÄT BEI EINER TELEKOMMUNIKATIONSSTROMSTATION
SYSTÈME D'AUTOMATISATION DE MESURE DE CAPACITÉ DE BATTERIES DE SECOURS DANS UNE CENTRALE ÉNERGÉTIQUE DE TÉLÉCOMMUNICATIONS

(30) Priority: 12.03.2013 PL 40311813
(43) Date of publication of application: 20.01.2016
(73) Proprietor: Instytut Lacznosci Panstwowy Instytut Badawczy, 04-894 Warszawa (PL)
(72) Inventor: GODLEWSKI, Pawel, PL-04-955 Warszawa (PL); KOBUS, Ryszard, PL-01-926 Warszawa (PL); CHOJNACKI, Bogdan, PL-01-355 Warszawa (PL); NIECHODA, Kazimierz, PL-04-331 Warszawa (PL); OLECHOWSKI, Krzysztof, PL-03-909 Warszawa (PL)
(74) Representative: Karczmitowicz, Teresa Ewa
(86) International application number: PCT/PL2013/000136
(87) International publication number: WO 2014/142685

(56) References cited:
- WO-A1-98/58271
- WO-A1-2009/091395
- WO-A2-2004/049540
- DE-U1- 29 913 613
- US-A1- 2003 107 859
- US-A1- 2010 007 506
- US-A1- 2012 098 498
- "TBA160-IL PORTABLE DEVICE", , 1 July 2011 (2011-07-01), XP055112094, Retrieved from the Internet: URL:http://www.itl.waw.pl/images/stories/o ferta/urzadzenia_i_systemy/img/TBA160/Manu al_TBA160-IL.pdf [retrieved on 2014-04-04]

## Description

The present invention relates to a system designed to automate the measurement of backup-batteries capacity in the telecommunications power station, which are the energy reserve for the telecommunication equipment.

To ensure continuous operation of the technical infrastructure in the telecommunication network, uninterrupted power supply even in case of power failure in the power grid 230/400V is required. Therefore, a typical power system for the telecommunication equipment installed in the facility consists of the power station with the mains voltage rectifiers fed with 230/400V and the backup power source consisting of several chains of batteries, usually of nominal voltage of 48 V, connected for example by fuses and common low-voltage switch to the outputs of rectifying units and to the inputs of the energy receivers, i.e. the loads.

In a normal operating state the rectifiers provide so called "buffering voltage" to the loads and the batteries, and then the batteries fed with small preservative current are not discharged. In case of power failure in the power grid, delivery of energy to the loads is taken by the batteries, and after returning of voltage the rectifiers again provide power to the loads while charging the batteries. Security of power supply to the facility depends on availability of energy in the power grid, and in the absence thereof - of the energy stored in the batteries. Depending on the technology applied, the manufacturers determine the backup-battery life time on 5-10-20 years, but disadvantageous operating conditions cause their degradation, i.e. reduction of available capacity below 80% of nominal capacity, often after half this time. Therefore the batteries should be either exchanged frequently, which is an expensive procedure, or checked and replaced if out of order.

The most accurate method of assessing available capacity of the battery (accuracy of about ±1%) is a controlled discharge with a preset current, usually with so-called 10-hours current or 20-hours current. With this method the manufacturers determine the nominal capacity of manufactured batteries. This method is commonly used to measure the battery available capacity, when disconnected "manually" from the loads by the discharge rheostats maintaining a constant discharge current or by automatic devices. An example of such device is TBA160-IL which is described in more detail below. The staff needs to be involved at least at the stages of disconnection and connection of tested battery. The inventions known from the patents discussed hereinafter enable remote initiation of the battery discharge in the power stations adapted to such functions.

Polish patent PL201960 describes the converter system for the telecommunications DC power station with two batteries. This system eliminates the need for participation of the servicing personnel. According to the description, during controlled discharge-charge procedure with the DC programmed current, the converter disconnects through its two relays with switchable contacts the selected battery from the power station circuits and connects it to the converter built from transistors, capacitors, and inductor. A well-known drawback of this solution is a large current flowing through the relay contacts inside the device in the state of the loads supply from the battery and also the need to switch-off both batteries for disassembly of the appliance for repair or maintenance.

Polish patent application PL390982 discloses a method and a system for remote diagnostics of backup-batteries, especially in the ICT systems. According to this solution, in the power station an additional separated bus is connected to the batteries through individual lines, by another contactor to the rectifier units, through another contactor to a group of selected energy loads, and through yet another contactor it is connected during normal bus operation to the system negative bus of the power station. The disadvantage of this solution is a large number of high-current power contactors connecting the loads, complicated procedure of discharging the controlled battery with DC current by adjusting the output current in a separate, tailored to that function group of rectifiers, and requirement for a group of loads that do not require guaranteed supply.

From American patent application US2009021216 A1 a solution is known for charging and remotely managed, controlled discharging of two batteries, where individual electronic contactors, made of transistors, are used to connect the loads to the rectifiers and to each of the batteries, and individual for each battery charging systems. A disadvantage of this solution is that the value of the discharging current is determined by the loads which may change over time, instead of the preferred 10-hours current or 20-hours current, and inability to use energy of controlled battery to sustain the load in case of the power failure in the power grid. *This is* because one cannot directly connect two batteries with different levels of charge/discharge to the energy receivers.

International patent application WO9858271 A1 discloses an apparatus for controllably charging and discharging individual battery cells or groups of battery cells in a string of batteries employed as a back-up power supply. The apparatus comprises an isolation circuit for at least partially isolating the battery string from the load bus and primary supply, a switching network including at least two controlled switches arranged to selectively form circuits for discharging one or more cells, and a logic circuit for selecting which of the cells will be discharged. In certain disclosed embodiments, the logic circuit and switching network combine to apportion charging current to individual battery cells or groups of cells in accordance with their charging needs.

German application of a utility model DE29913613 U1 and European patent application EP1074851 A1 provide an arrangement for monitoring a battery comprised of several series-connected battery sub-units and lying in a battery branch parallel to a consumer-load connected to a controlled power supply device. It has a measuring device for ascertaining the battery current and the voltage at the battery or the voltages at the battery sub-units, and for gathering information there from about the operational state of the battery, or that of the battery sub-units. A final control element e.g. a semiconductor switch is arranged in the battery branch, and a control device operating in conjunction with the measurement device controls the power supply device and the final control element for adjusting various operating conditions of the battery.

Another Polish patent application PL398791 discloses a method and a system for remote controlling of available capacity of backup-batteries in the telecommunications power station, where for individual control of each battery the system negative rail of the power station is connected to the batteries through individually-controlled high-current contactors, replacing the common low-voltage switch, and where the controlled battery is connected through the low-current contactor to the input of the controlling-measuring device TBA-ST, permanently installed in the power station. On demand from centralized monitoring system this device measures capacity of the battery using the constant current controlled discharge. A disadvantage of this solution is that it is only suitable for use in new power stations delivered to operators, and cannot be used for automate testing of the battery in the power plants already in operation.

A portable device for backup-battery testing TBA160-IL (http://www.itl.waw.pl/images/stories/oferta/urzadzenia_i_systemy/img/TBA160/ Manual_TBA160-IL.pdf) is designed for controlled discharging and charging the lead-acid batteries, especially of VRLA type, in particular in the telecommunication sites. The telecommunication equipment is supplied by a power system. Energy taken from discharged battery is fed to the supplied equipment, temporally decreasing the current drawn from the system rectifiers. The device TBA160-IL enables the operator to program the test cycle, which consists of equalizing charging, controlled discharging, and recharging the batteries in the telecommunication site. The operator connects the TBA160-IL device to the controlled battery disconnected from the power system, sets the battery tests, sends the results to a PC and rearranges the power system. The device is programmed with built-in keyboard. The process results can be presented on a display, transferred to a PC via LAN10/100 or SD card, and processed with dedicated software.
The invented system for automation of measurement of backup-batteries capacity in the telecommunications power station comprises a control device (TBA-BN), where the system positive bus (+) is directly connected to positive terminals of power supply, loads and batteries, and the system negative bus (-) is directly connected to negative terminals of power supply and loads, and where the rectifying units stand for the power supply. First input (-B) of the control device (TBA-BN) is connected to first terminal (b) of the battery, second input (-S) of the control device (TBA-BN) is connected to second terminal (s) of the power supply, and third input (M) of the control device (TBA-BN) is connected to the system positive bus (+). The control device (TBA-BN) comprises a control system (ST) configured to control four electronic connectors (T1-T4) directly through dedicated I/O connections coupling the control system (ST) to each of four electronic connectors (T1-T4) individually. The control system (ST) is also configured to control an additive-subtractive converter (DC/DC), separate from four electronic connectors (T1-T4), to effect in normal mode of operation a connection of the batteries (B1-Bn) to negative bus of a set of rectifying units (PR1-PR2) through an electronic contactor (EP), and in a capacity measuring mode of operation to effect a constant current charge/discharge of the batteries (B1-Bn). The control device (TBA-BN) connects negative pole (-) of each of the batteries (B1-Bn) to negative bus (-) of the set of rectifying units (PR1-PR2) through the terminal (b), first input (-B) of the control device (TBA-BN), the electronic contactor (EP) and second input (-S) of the control device (TBA-BN). The electronic contactor (EP) comprises two electronic connectors, first electronic connector (T1) having first diode (D1) in parallel, and second electronic connector (T2) having second diode (D2) in parallel, and both electronic connectors first (T1) and second (T2) are connected serially by the respective other diode's cathod*e*. First input (-B) of the control device (TBA-BN) is also connected through third resistor (R3) connected in parallel to third electronic connector (T3), and further connected to negative terminal of first capacitor (C1) and first input (1) of a bidirectional additive-subtractive converter (DC/DC), whereas second input (2) of the bidirectional additive-subtractive converter (DC/DC) is connected to negative terminal of second capacitor (C2) and fourth electronic connector (T4), connected in parallel to fourth resistor (R4) connected to second input (-S) of the control device (TBA-BN). Third input (M) of the control device (TBA-BN) is internally connected to third input (3) of the bidirectional additive-subtractive converter (DC/DC), to positive terminal of first capacitor (C1) and to positive terminal of second capacitor (C2). The circuit comprising the electronic contactor (EP) is connected in parallel to the circuit comprising third electronic connector (T3) connected in parallel to third resistor (R3), the bidirectional additive-subtractive converter (DC/DC), and fourth electronic connector (T4), connected in parallel to fourth resistor (R4).
Preferably, first current measuring device (LEM1) is connected in the control device (TBA-BN) between first input (-B) and first electronic connector of the electronic connector (T1), its output connected to the control system (ST) of the control device.

It is advantageous when in the control device (TBA-BN) between its first inputs (-B) and the first input of the bidirectional additive-subtractive converter (DC/DC), directly before or directly behind the third electronic connector (T3), a second current measuring device (LEM2) is connected, its output connected to the control system (ST) of the control device.
In preferred embodiment, the MOS transistors are used as first, second, third and fourth electronic connectors (T1...T4) in the control device.
In another embodiment, the relays are used as first, second, third and fourth electronic connectors (T1...T4) in the control device.
In also recommended embodiment, the contactors are used as first, second, third and fourth electronic connectors (T1...T4) in the control device.

The advantage of proposed invention is a possibility to automate the control of backup-batteries capacity, with a method of controlled discharge, in the telecommunications power stations working with previously used electrical systems, through simple installation of the control device in the circuit of each of the batteries, without interrupting exploitation of the telecommunications equipment. This solution is particularly suitable for small power stations, with the batteries of capacity of 80 - 200 Ah and working with the loads currents of up to about 100 A.

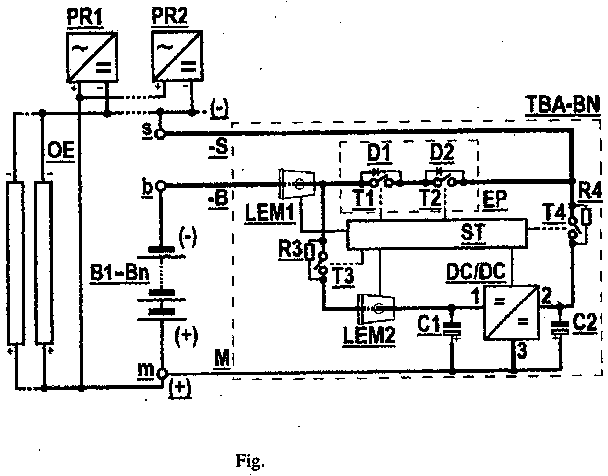

Preferred embodiment of the system for automated measurement of backup-batteries capacity in the telecommunications power station, according to the invention, is illustrated on the drawing showing a block diagram of the system.
In the system for automation of measurement of backup-batteries capacity in the telecommunications power station, in particular in the traditional (not modified) telecommunications power station supplying the DC current, the system positive bus (+) is connected to positive terminals of all rectifying units PR1-PRn, all energy receivers (loads) OE and all batteries B1-Bn, whereas the system negative bus (-) is connected to negative terminals of all rectifying units PR1-PR2, and all loads OE. Between second terminal s, and negative poles (-) of each battery B1-Bn with first terminal b, dedicated to each battery B1-Bn the control device TBA-BN is connected as follows: first input B of the control device TBA-BN is connected to first terminal b connected to the battery, second input - S of the control device TBA-BN is connected to second terminal s connected to the rectifying units PR1-PR2, and third input M of this control device TBA-BN is connected to the system positive bus (+). First input -B of the control device TBA-BN is connected internally in the device, through the ST-controlled electronic contactor EP containing two electronic connectors: first connector T1 and second connector T2, with its second input -S. First input -B of the control device TBA-BN is connected also to third resistor R3, connected in parallel with third electronic connector T3 connected to negative terminal of first capacitor C1 and first input 1 of the bidirectional additive-subtractive converter DC/DC, which through second input 2 is connected to negative terminal of second capacitor C2 and fourth electronic connector T4, connected in parallel with fourth resistor R4, which in turn is connected to second input -S of the control device TBA-BN. Third input M of the control device TBA -BN is connected internally to third input 3 of the bidirectional additive-subtractive converter DC/DC, to positive terminal of first capacitor C1 and positive terminal of second capacitor C2.
Preferably first current measuring subsystem LEM1, with its output connected to the control subsystem ST of the control device TBA-BN is connected in the control device TBA-BN between first input -B and first transistor T1 of the electronic contactor EP.
It is advantageous when second current measuring subsystem LEM2, with its output connected to the control system ST of the control device TBA-BN, is connected in the control device TBA-BN between first input -B, and first input 1 of the bidirectional additive-subtractive converter DC/DC, immediately before third electronic connector T3 or immediately behind third electronic connector T3.
It is also recommended to use the MOS transistors, relays or contactors in the control device TBA-BN as first electronic connector T1, second electronic connector T2, third electronic connector T3, and fourth electronic connector T4. During normal operation, each of the batteries is connected to the system negative bus of the power station through the electronic contactors EP, comprised in the control devices TBA-BN. When selected battery is to be controlled, i.e. its capacity is to be measured with the controlled discharge method, the control system ST of the designated control device TBA-BN switches-off second electronic connector T2 of the electronic contactor EP and switches-on third electronic connector T3 and fourth electronic connector T4 in the circuits of the bidirectional additive-subtractive converter DC/DC (disconnected at rest, third and fourth electronic connectors T3 and T4 allow for smooth charging of first capacitor C1 and second capacitor C2 through third resistor R3 and fourth resistor R4, when installing the device), and the operation of the converter is controlled to discharge and/or to charge the controlled battery with a constant current. If during the inspection of the battery the network voltage of 230/400V fails and the voltage on the system negative rail and on the loads OE decreases, the powering is supported with energy contained in the controlled battery by the current flow in the electronic contactor EP through second diode D2 of switched-off second electronic connector T2 and switched-on first electronic connector T1, while the current flow is not limited by the current capacity of the bidirectional additive-subtractive converter DC/DC of the control device TBA-BN.

## Claims

1. A system for automation of measurement of backup batteries capacity in the telecommunication power station, comprising a control device (TBA-BN), where the system positive bus (+) is directly connected to positive terminals of the rectifying units, loads and batteries, and the system negative bus (-) is directly connected to negative terminals of rectifying units and loads, and where first input (-B) of the control device (TBA-BN) is connected to first terminal (b) of the battery, second input (-S) of the control device (TBA-BN) is connected to second terminal (s) of the rectifying units, and third input (M) of the control device (TBA-BN) is connected to the system positive bus (+), and where the control device (TBA-BN) connects negative pole (-) of each of the batteries (B1-Bn) to negative bus (-) of the set of the rectifying units (PR1-PR2), and comprises a control system (ST), **characterized in that** the control system (ST) is configured to control four electronic connectors (T1-T4) directly and individually through four dedicated I/O connections coupling the control system (ST) to each of said four electronic connectors (T1-T4) directly and individually, and where the control device (TBA-BN) comprises an additive-subtractive converter (DC/DC), separate from said four electronic connectors (T1-T4), to effect in normal mode of operation a connection of the batteries (B1-Bn) to negative bus of a set of rectifying units (PR1-PR2) through an electronic contactor (EP), and in a capacity measuring mode of operation to effect a constant current charge/discharge of the batteries (B1-Bn), wherein connection of negative pole (-) of each of the batteries (B1-Bn) to negative bus (-) of the set of rectifying units (PR1-PR2) is realized through the circuit comprising the terminal (b), first input (-B) of the control device (TBA-BN), the electronic contactor (EP) and second input (-S) of the control device (TBA-BN), and where the electronic contactor (EP) comprises a series of two electronic connectors controlled by the control system (ST), first electronic connector (T1) having first diode (D1) in parallel, and second electronic connector (T2) having second diode (D2) in parallel, and both electronic connectors first (T1) and second (T2) are connected serially by the respective other diode's cathode, and where first input (-B) of the control device (TBA-BN) is also connected through third resistor (R3) connected in parallel to third electronic connector (T3), and further connected to negative terminal of first capacitor (C1) and first input (1) of a bidirectional additive-subtractive converter (DC/DC), whereas second input (2) of the bidirectional additive-subtractive converter (DC/DC) is connected to negative terminal of second capacitor (C2) and fourth electronic connector (T4), connected in parallel to fourth resistor (R4) connected to second input (-S) of the control device (TBA-BN), and where third input (M) of the control device (TBA-BN) is internally connected to third input (3) of the bidirectional additive-subtractive converter (DC/DC), to positive terminal of first capacitor (C1) and to positive terminal of second capacitor (C2), and where the circuit comprising the electronic contactor (EP) is connected in parallel to the circuit comprising third electronic connector (T3) connected in parallel to third resistor (R3), the bidirectional additive-subtractive converter (DC/DC), and fourth electronic connector (T4), connected in parallel to fourth resistor (R4).

2. The system according to claim 1, **characterized in that** the control device (TBA-BN) comprises first current measuring device (LEM 1) connected in between first input (-B) and first electronic connector (T1) of the electronic contactor (EP), and its output connected to the control system (ST).

3. The system according to claim 1 or 2, **characterized in that** the control device (TBA-BN) comprises second current measuring device (LEM 2) connected in between first input (-B) and first input of the bidirectional additive-subtractive converter (DC/DC), directly before or directly behind third electronic connector (T3), and its output connected to the control system (ST).

4. The system according to claim 1 or 2 or 3, **characterized in that** MOS transistors are used as first (T1), second (T2), third (T3) and fourth (T4) electronic connectors.

5. The system according to claim 1 or 2 or 3, **characterized in that** relays are used as first (T1), second (T2), third (T3) and fourth (T4) electronic connectors.

6. The system according to claim 1 or 2 or 3, **characterized in that** contactors are used as first (T1), second (T2), third (T3) and fourth (T4) electronic connectors.

## Patentansprüche

1. Schaltung zur Automatisierung der Messung der Kapazität der Reservebatterien eines Telekommunikationskraftwerks bestehend aus einer Kontrollanlage (TBA-BN), wobei die Plusschiene (+) direkt mit den Plusklemmen der Gleichrichteranlagen, Verbraucher und Batterien verbunden ist, und die Minusschiene (-) direkt mit den Minusklemmen der Gleichrichteranlagen, Verbraucher und Batterien verbunden ist und wobei der erste Eingang (-B) der Kontrollanlage (TBA-BN) an die erste Klemme (b) der Batterie und der zweite Eingang (-S) der Kontrollanlage (TBA-BN) an die zweite Klemme (s) der Gleichrichteranlagen und der dritte Eingang (M) der Kontrollanlage (TBA-BN) an die Plusschiene (+) der Schaltung angeschlossen sind, wobei die Kontrollanlage TBA-BN) den Minuspol (-) der einzelnen Batterien (B1-Bn) mit der Minusschiene (-) der gleichrichteranlagengruppe (PR1-PR2) verbindet und aus dem Kontrollsystem besteht (ST), **dadurch gekennzeichnet, dass** das Kontrollsystem (ST) zur Kontrolle von vier Elektronikanschlüssen (T1-T4) konfiguriert ist, direkt und individuell über vier spezielle Eingänge/Ausgänge zur direkten und individuellen Verbindung des Kontrollsystems (ST) mit jedem der vier Elektronikanschüsse (T1-T4), wobei die Kontrollanlage (TBA-BN) mit einem additiv-subtraktiven Umformer (DC/DC) ausgerüstet ist, der von den genannten vier Elektronikanschlüssen (T1-T4) getrennt ist, damit beim normalen Betrieb den Anschluss der Batterien (B1-Bn) an die Minusschiene der Gleichrichteranlagen (PR1-PR2) über das Elektronikrelais (EP) zu beeinflussen und bei Messung der Kapazität den Gleichstrom der Aufladung/Entladung der Batterie zu beeinflussen (B1-Bn), wobei der Anschluss des Minuspols (-) jeder Batterie (B1-Bn) an die Minusschiene (-) der Gleichrichteranlagengruppe (PR1-PR2) über einen Stromkreis erfolgt, der aus der Klemme (b) des ersten Eingangs (-B) der Kontrollanlage (TBA-BN), dem Elektronikrelais (EP) und dem zweiten Eingang (-S) der Kontrollanlage (TBA-BN) besteht und wobei das Elektronikrelais (EP) aus einer Gruppe von zwei elektronischen Anschlüssen mit Steuerung über das Kontrollsystem (ST) besteht; am ersten elektronischen Anschluss (T1) ist die erste Diode (D1) parallel und am zweiten elektronischen Anschluss ist die zweite Diode (D2) parallel angeschlossen und die beiden elektronischen Anschlüsse, der erste (T1) und der zweite (T2) sind in Reihenschaltung über die Kathode einer anderen entsprechenden Diode angeschlossen, wobei der erste Eingang (-B) der Kontrollanlage TBA-BN) über einen dritten Widerstand (R3) parallel mit dem dritten elektronischen Anschluss (T3) und dann mit der Minusklemme des ersten Kondensators (C1) und dem ersten Eingang (1) des additiv-subtraktiven doppelwirkenden Umformers (DC/DC) verbunden ist, wobei der zweite Ausgang (2) dieses Umformers (DC/DC) mit der Minusklemme des zweiten Kondensators (C2) und dem vierten elektronischen Anschluss (T4) verbunden ist, der an den vierten Widerstand (R4) parallel angeschlossen ist, der mit dem Eingang der zweiten (-S) Kontrollanlage (TBA-BN) verbunden ist, wobei der dritte Ausgang (M) der Kontrollanlage (TBA-BN) intern an den dritten Ausgang (3) des additiv-subtraktiven Umformers (DC/DC), an die Plusklemme des ersten Kondensators (C1) und an die Plusklemme des zweiten Kondensators angeschlossen ist (C2), wobei der Stromkreis mit dem elektronischen Relais (EP) parallel mit dem Stromkreis verbunden ist, der den dritten elektronischen Anschluss (T3) hat, angeschlossen parallel an den dritten Widerstand (R3) des doppelwirkenden additiv-subtraktiven Umformers (DC/DC), wobei der vierte elektronische Anschluss (T) an den vierten Widerstand (R4) parallel angeschlossen ist.

2. Schaltung nach Anspruch 1, **dadurch gekennzeichnet, dass** die Kontrollanlage (TBA-BN) über das erste Gerät zur Messung der Stromstärke (LEM 1) verfügt, das zwischen dem ersten Eingang (-B) und dem ersten elektronischen Anschluss (T1) des elektronischen Relais (EP) angeschlossen ist und sein Ausgang mit der Steueranlage (ST) verbunden ist.

3. Schaltung nach Anspruch 1, **dadurch gekennzeichnet, dass** die Kontrollanlage (TBA-BN) über das zweite Gerät zur Messung der Stromstärke (LEM 2) verfügt, das zwischen dem ersten Eingang (-B) und dem ersten Eingang der doppelwirkenden additiv-subtraktiven Umformers (DC/DC) angeschlossen ist, direkt vor oder direkt nach dem dritten elektronischen Anschluss (T2) und wobei sein Ausgang mit der Steueranlage (ST) verbunden ist.

4. Schaltung nach Anspruch 1 oder 2 oder 3, **dadurch gekennzeichnet, dass** die Transistoren MOS als der erste (T1), der zweite (T2), der dritte (T3) und der vierte elektronische Anschluss dienen.

5. Schaltung nach Anspruch 1 oder 2 oder 3, **dadurch gekennzeichnet, dass** die Relais als der erste (T1), der zweite (T2), der dritte (T3) und der vierte elektronische Anschluss dienen.

6. Schaltung nach Anspruch 1 oder 2 oder 3, **dadurch gekennzeichnet, dass** die Schütze als der erste (T1), der zweite (T2), der dritte (T3) und der vierte elektronische Anschluss dienen.

## Revendications

1. Un système pour l'automatisation de mesure de la capacité des batteries de réserve dans la centrale des télécommunications, comprenant un dispositif de contrôle (TBA-BN), où le bus positif du système (+) est connecté directement aux bornes positives des unités de redressement, des récepteurs et batteries, et le bus négatif du système (-) est connecté directement aux bornes négatives des unités de redressement et des récepteurs, et où la première entrée (-B) du dispositif de contrôle (TBA-BN) est connectée à la première borne (b) de la batterie, la deuxième entrée (-S) du dispositif de contrôle (TBA-BN) est connectée à la deuxième borne (s) des unités de redressement et la troisième entrée (M) du dispositif de contrôle (TBA-BN) est connectée au bus positif du système (+), et où le dispositif de contrôle (TBA-BN) relie le pôle négatif (-) de chacune des batteries (B1-Bn) au bus négatif (-) du groupe des unités de redressement (PR1-PR2), et comprend un système de contrôle (ST), **caractérisé en ce que** le système de contrôle (ST) est configuré pour contrôler quatre connecteurs électroniques (T1-T4) directement et individuellement par quatre connecteurs E / S dédiés reliant directement et individuellement le système de contrôle (ST) avec chacun des quatre connecteurs électroniques mentionnés (T1-T4), et où le dispositif de contrôle (TBA-BN) est équipé d'un convertisseur additif-soustractif (DC / DC) ; séparé des quatre connecteurs électroniques mentionnés (T1-T4) pour affecter, en mode de travail normal, la connexion des batteries (B1-Bn) au bus négatif du groupe des unités de redressement (PR1-PR2) par l'intermédiaire du contacteur électronique (EP) et pour affecter, en mode de mesure de la capacité, le courant constant de charge / décharge des batteries (B1-Bn), où la connexion du pôle négatif (-) de chaque batterie (B1-Bn) au bus négatif (-) du groupe des unités de redressement (PR1-PR2) est réalisée par un circuit constitué de la borne (b) de la première entrée (-B), du dispositif de contrôle (TBA-BN), du contacteur électronique (EP) et de la deuxième entrée (-S) du dispositif de contrôle (TBA-BN), et où le contacteur électronique (EP) est constitué d'un groupe de deux connecteurs électroniques commandés par le système de contrôle (ST), dans le premier connecteur électronique (T1) la première diode (D1) est connectée en parallèle et dans le second connecteur électronique (T2) la seconde diode (D2) est connectée en parallèle et les deux connecteurs électroniques, le premier (T1) et le second (T2) sont connectés en série par la cathode d'une autre diode appropriée, et où la première entrée (-B) du dispositif de contrôle (TBA-BN) est également connectée par l'intermédiaire de la troisième résistance (R3) connectée en parallèle au troisième connecteur électronique (T3), et puis connectée à la borne négative du premier condensateur (C1) et à la première entrée (1) du convertisseur bidirectionnel additif-soustractif (DC / DC) tandis que la deuxième entrée (2) du convertisseur bidirectionnel additif-soustractif (DC / DC) est connectée à la borne négative du second condensateur (C2) et quatrième connecteur électronique (T4), connecté en parallèle à la quatrième résistance (R4) connectée à la deuxième entrée (-S) du dispositif de contrôle (TBA-BN), et où la troisième entrée (M) du dispositif de contrôle (TBA-BN) est connectée en interne à la troisième entrée (3) du convertisseur bidirectionnel additif-soustractif (DC / DC), à la borne positive du premier condensateur (C1) et la borne positive du deuxième condensateur (C2), et où le circuit comprenant le contacteur électronique (EP) est connectée en parallèle au circuit comprenant le troisième connecteur électronique (T3), connecté en parallèle à la troisième résistance (R3), au convertisseur bidirectionnel additif-soustractif (DC / DC), et le quatrième connecteur électronique (T4) est connecté en parallèle à la quatrième résistance (R4).

2. Le système selon la revendication 1, **caractérisé en ce que** le dispositif de contrôle (TBA-BN) comprend le premier dispositif de mesure de l'intensité (LEM 1) connecté entre la première entrée (-B) et le premier connecteur électronique (T1) du contacteur électronique (EP) et sa sortie est reliée au système de commande (ST).

3. Le système selon les revendications 1 et 2, **caractérisé en ce que** le dispositif de contrôle (TBA-BN) comprend le second dispositif de mesure de l'intensité (LEM 2) connecté entre la première entrée (-B) et la première entrée du convertisseur bidirectionnel additif-soustractif (DC / DC), directement devant ou directement derrière le troisième connecteur électronique (T3) et sa sortie est reliée au système de commande (ST).

4. Le système selon les revendications 1 ou 2 ou 3, **caractérisé en ce que** les transistors MOS servent de premier (T1), deuxième (T2), troisième (T3) et quatrième connecteurs électroniques.

5. Le système selon les revendications 1 ou 2 ou 3, **caractérisé en ce que** les relais servent de premier (T1), deuxième (T2), troisième (T3) et quatrième connecteurs électroniques.

6. Le système selon les revendications 1 ou 2 ou 3, **caractérisé en ce que** les contacteurs servent de premier (T1), deuxième (T2), troisième (T3) et quatrième connecteurs électroniques.
